# EUROPÄISCHE PATENTANMELDUNG

(11) **EP 1 391 993 A2**
(43) Veröffentlichungstag der Anmeldung: **25.02.2004**
(21) Anmeldenummer: 03015530.3
(22) Anmeldetag: 10.07.2003
(51) Int. Cl.: H03M 1/08

(54) **Verfahren und Vorrichtung zur Analog-Digitalwandlung**

(30) Priorität: 20.08.2002 DE 10238028
(71) Anmelder: Infineon Technologies AG, 81669 München (DE)
(72) Erfinder: Kuttner, Franz, 9524 St. Magdalen (AT)
(74) Vertreter: Banzer, Hans-Jörg, Dipl.-Ing.

(57) **Zusammenfassung**

Zur Verbesserung des Signal-Rausch-Abstands bei der Analog-Digital-Wandlung zeitdiskreter analoger Eingangswerte (1) wird ein Quantisierer (4) verwendet, bei dem am Ende jeder Wandlung zusätzlich zu einem digitalen Ausgangswert (2) ein Quantisierungsfehler (3) in analoger Form abgegriffen werden kann. Der Quantisierungsfehler (3) wird in einem Zwischenspeicher (5) zwischengespeichert und mittels eines Subtrahierglieds (6) auf wenigstens einen Eingangswert (1) einer nächsten Wandlung rückgekoppelt. Vorteilhafterweise weist der Quantisierer (4) eine Wandlungsfrequenz auf, die über dem Doppelten der maximal in den Eingangswerten (1) enthaltenen Frequenz liegt, so dass die Analog-Digital-Wandlung im Oversampling-Betrieb arbeitet. Bei der Rückkopplung des Quantisierungsfehlers (3) auf die Eingangswerte (1) werden vorzugsweise auf einen Eingangswert (1) die Quantisierungsfehler (3) mehrerer, unterschiedlich viele Wandlungen vorausgegangener Wandlungen rückgekoppelt. Die Erfindung kann bei allen herkömmlichen Quantisierern (4) angewendet werden, bei denen der Quantisierungsfehler (3) in analoger Form abgegriffen werden kann, so dass es auch mit solchen Quantisierern (4) möglich ist, mit Hilfe des Verfahrens des Noise-Shaping das Quantisierungsrauschen in höherfrequente Spektralbereiche zu verschieben, um in einem Nutzspektralbereich den Signal-Rausch-Abstand zu verbessern bzw. das Quantisierungsrauschen zu verringern.

## Beschreibung

Die vorliegende Erfindung betrifft ein Verfahren sowie eine Vorrichtung zur Analog-Digital-Wandlung zeitdiskreter analoger Eingangswerte.

Zur Analog-Digital-Wandlung zeitdiskreter analoger Eingangswerte sind zahlreiche Verfahren bzw. Vorrichtungen bekannt. Dabei lassen sich die Analog-Digital-Wandler, im folgenden auch ADC genannt, in zwei Gruppen unterteilen. Zum einen die Nyquist-ADC, die bei jeder Wandlung einem analogen Eingangswert einen digitalen Ausgangswert zuordnet, wobei die Wandlungsfrequenz zur Erfüllung des Nyquist-Kriteriums wenigstens das Doppelte der höchsten zu wandelnden Frequenz in den Eingangswerten beträgt. Derartige Wandler sind beispielsweise Wandler nach dem Verfahren der sukzessiven Approximation, Flash-Wandler bzw. Parallel-Wandler oder Pipeline-Wandler.

Weiterhin sind Δ-Modulatoren und ΣΔ-Modulatoren bekannt, bei denen analoge Eingangswerte digitalisiert werden, das digitale Ausgangssignal mittels eines Digital-Analog-Wandlers wieder analogisiert wird, und dieser Analogwert auf wenigstens einen folgenden analogen Eingangswert rückgekoppelt wird. Derartige Analog-Digital-Wandler werden mit einer höheren Frequenz betrieben, als es nach dem Nyquist-Kriterium erforderlich wäre. Dieses wird auch als Oversampling bezeichnet. Damit kann eine Verteilung des Quantisierungsrauschens, das durch die unvermeidlichen Quantisierungsfehler entsteht, über einen größeren Spektralbereich erreicht werden. Das Quantisierungsrauschen kann anschließend mit Hilfe geeigneter Filter besser aus dem digitalen Ausgangssignal entfernt werden, wobei vorteilhafterweise Digitalfilter eingesetzt werden können. Da beim Oversampling der Abstand zwischen der Wandlungsfrequenz und der höchsten im zu wandelnden Eingangssignal enthaltenden Frequenz vergrößert ist, kann vorteilhafterweise die Flankensteilheit verringert werden. Weiterhin ist bei Δ-Modulatoren bzw. ΣΔ-Modulatoren das Verfahren des Noise-Shaping bekannt, bei welchem Verfahren das Quantisierungsrauschen durch geeignete Rückführung des digitalen Ausgangssignals des Quantisierers aus dem Nutzband heraus in das außerhalb liegende Teilband verschoben wird, wo es herausgefiltert werden kann, so dass im Nutzband das Quantisierungsrauschen weiter verringert werden kann. Da bei Δ-Modulatoren bzw. ΣΔ-Modulatoren ohnehin der vom Quantisierer gelieferte Digitalwert wieder in einem Digital-Analog-Wandler analogisiert und rückgekoppelt wird, kann in solchen Fällen mit geringem Aufwand das Noise-Shaping zusätzlich eingeführt werden.

Die Durchführung des Noise-Shaping bei Nyquist-Analog-Digital-Wandlern ist bislang nicht bekannt, so dass derartige ADC ein erhöhtes Quantisierungsrauschen aufweisen.

Der vorliegenden Erfindung liegt die Aufgabe zu Grunde, ein Verfahren bzw. eine Vorrichtung zur Analog-Digital-Wandlung zeitdiskreter analoger Eingangswerte zu schaffen, wobei mit geringem Aufwand das Quantisierungsrauschen verringert werden kann.

Erfindungsgemäß wird dies Aufgabe durch ein Verfahren mit den Merkmalen des Anspruchs 1 bzw. eine Vorrichtung mit den Merkmalen des Anspruchs 13 gelöst. Die Unteransprüche definieren jeweils vorteilhafte und bevorzugte Ausführungsformen der vorliegenden Erfindung.

Erfindungsgemäß wird beim Quantisierer analog der Quantisierungsfehler ermittelt und auf einen folgenden Eingangswert rückgekoppelt. Dabei macht man sich die Tatsache zu Nutze, dass in den meisten Analog-Digital-Wandlern innerhalb der Schaltung der Quantisierungsfehler in analoger Form vorliegt und abgegriffen werden kann. Der Quantisierungsfehler wird ermittelt und auf wenigstens einen folgenden Eingangswert rückgekoppelt, wobei dies beispielsweise mit Hilfe eines analogen Subtrahiergliedes erfolgen kann.

Zum Rückkoppeln auf einen folgenden Eingangswert wird der Quantisierungsfehler einer bestimmten Wandlung vorzugsweise zwischengespeichert. Dies kann beispielsweise in einem Sample-and-Hold-Glied geschehen. Wenn jeder Quantisierungsfehler einer Wandlung eines bestimmten Einjegangswerts auf mehrere folgende Eingangswerte rückgekoppelt werden soll, können mehrere Speicherglieder, insbesondere in Form von Sample-and-Hold-Gliedern, vorgesehen sein, um Quantisierungsfehler auch für mehrere Wandlungsschritte des Quantisierers speichern zu können.

Äquivalent zu der Rückkopplung eines Quantisierungsfehlers auf wenigstens einen folgenden Eingangswert ist die Rückkopplung auf einen bestimmten Eingangswert von wenigstens einem Quantisierungsfehler einer vorangegangenen Wandlung. In beiden Fällen ergibt sich, dass auf einen Eingangswert Quantisierungsfehler wenigstens einer vorausgegangenen Wandlung rückgekoppelt werden. Wenn auf einen Eingangswert mehrere, unterschiedlich viele Wandlungen vorausgegangene Quantisierungsfehler rückgekoppelt werden, wird vorzugsweise eine Verzögerungskette vorgesehen, in der die Quantisierungsfehler wie in einem Schieberegister durchgeschoben werden, wobei an den einzelnen Stellen der Verzögerungskette nach jeder Wandlung der Quantisierungsfehler abgegriffen werden kann, der eine bestimmte Anzahl von Wandlungen vorausgegangen ist.

Wenn unterschiedlich viele Wandlungen vorausgegangene Quantisierungsfehler auf einen Eingangswert rückgekoppelt werden, können die unterschiedlichen Quantisierungsfehler mit bestimmten Faktoren bewertet werden, die in Abhängigkeit davon ausgewählt werden, wie viele Wandlungen der rückgekoppelte Quantisierungsfehler vorausgegangen ist. Auf diese Weise wird analog zu einem digitalen Filter eine Filterung erzielt, wobei im Gegensatz zu einem digitalen Filter zeitdiskrete Analogwerte verarbeitet werden.

Die Verzögerungskette kann insbesondere aus einer Kette von Sample-and-Hold-Gliedern aufgebaut sein.

Die Rückkopplung wenigstens eines Quantisierungsfehlers auf einen Eingangswert muss allgemein derart erfolgen, dass der Quantisierungsfehler ggf. mit einem Faktor bewertet von dem Eingangswert subtrahiert oder zu diesem addiert wird. Dazu können sich zusätzlich zu der Verwendung eines Addierglieds bzw. Subtrahierglieds abhängig von der Art des Quantisierers weitere Möglichkeiten ergeben. Wenn beispielsweise ein Quantisierer nach dem Verfahren der sukzessiven Approximation arbeitet, so umfasst der Quantisierer notwendigerweise einen Digital-Analog-Wandler, auf den zusätzlich zum Eingangswert der rückzukoppelnde Quantisierungsfehler aufgeschaltet werden kann. Wenn der verwendete Digital-Analog-Wandler wenigstens eine Parallel-Schaltung geschalteter Kapazitäten aufweist, die an einem Ende miteinander verbunden sind und deren anderes Ende steuerbar mit der zu quantisierenden Spannung oder einer Referenzspannung beaufschlagt werden kann, können einzelne Kondensatoren dieser Parallel-Schaltung so eingerichtet sein, dass sie an einem Ende entweder mit der Referenzspannung oder mit dem Quantisierungsfehler beaufschlagt werden können.

Bei Quantisierern nach dem Verfahren der sukzessiven Approximation liegt der Quantisierungsfehler am Ende des letzten Approximationsschritts vor und kann einfach als Differenz zwischen dem Ausgangssignal des Analog-Digital-Wandlers im Quantisierer und dem Eingangswert ermittelt werden. Üblicherweise weisen derartige Quantisierer einen Komparator zum Vergleich des Eingangswerts und des Ausgangswert des Analog-Digital-Wandlers auf, so dass der Quantisierungsfehler am Ende der Wandlung am Komparator anliegt und bei diesem abgegriffen werden kann.

Bei Verwendung eines Pipeline-Analog-Digital-Wandlers kann die zeitliche Verzögerung des Quantisierungsfehlers zum Beaufschlagen wenigstens eines nachfolgenden Eingangswerts mit besonders geringem Aufwand realisiert werden. Bei derartigen Pipeline-ADCs wird ein analoger Eingangswert analog zwischengespeichert und mit einer bestimmten Auflösung quantisiert. Das Quantisierungsergebnis beaufschlagt einen Digital-Analog-Wandler, dessen Ausgangssignal von dem gespeicherten Eingangswert subtrahiert wird, wobei die resultierende Spannungsdifferenz den Quantisierungsfehler der ersten Quantisierung darstellt und in einem nachfolgenden Verstärker verstärkt wird. Dieses Zwischenspeichern, Quantisieren und Verstärken des Quantisierungsfehlers eines Eingangswerts bildet eine Stufe des Pipeline-ADCs. In dieser einen Stufe wurde der Eingangswert bereits mit einer bestimmten Auflösung digitalisiert. Die dabei in der ersten Stufe ermittelten Digitalinformationen sind die höherwertigsten.

Der vom Verstärker verstärkte Quantisierungsfehler wird einer nächsten Stufe als Eingangswert geliefert, die in gleicher Weise wie die erste Stufe aufgebaut ist, so dass der verstärkte Quantisierungsfehler der ersten Stufe gespeichert und mit einer bestimmten Auflösung quantisiert wird, wobei dass Ergebnis der Quantisierung in einem Digital-Analog-Wandler der zweiten Stufe analogisiert und von dem gespeicherten Eingangswert der zweiten Stufe subtrahiert wird und die dabei entstehende Differenzspannung wieder verstärkt wird.

An die zweite Stufe können sich weitere Stufen anschließen. Die Auflösung, mit der in jeder Stufe der jeweilige Eingangswert quantisiert wird, ist beliebig. Grundsätzlich liefern die nachfolgenden Stufen niederwertigere Informationen als die jeweils vorangegangene.

Wenn beispielsweise in jeder Stufe der jeweilige Eingangswert mit zwei Bit quantisiert wird, so ergibt sich die gesamte Auflösung in Bit zu 2 Bit mal Anzahl der Stufen. Die Genauigkeit der in den einzelnen Stufen verwendeten Digital-Analog-Wandler muss dabei in geeigneter Weise angepasst werden. Wenn beispielsweise ein Pipeline-ADC eine Auflösung von insgesamt 10 Bit aufweist, so muss der Digital-Analog-Wandler der ersten Stufe unabhängig von der Auflösung der ersten Stufe eine Genauigkeit von wenigstens 10 Bit besitzen. Da in den nachfolgenden Stufen nur noch geringwertigere Informationen oder Bits gewonnen werden, verringert sich die Genauigkeitsanforderung an den Digital-Analog-Wandler in den nachfolgenden Stufen.

Ein wesentlicher Vorteil des Pipeline-ADC besteht darin, dass die Eingangswerte in jede Stufe gespeichert werden. Auf diese Weise muss die erste Stufe zur Verarbeitung des nächsten Eingangswerts nicht darauf warten, dass der vorangegangene Eingangswert von allen Stufen verarbeitet worden ist. Nach Verarbeitung beispielsweise eines ersten Eingangswerts durch die erste Stufe wird der dabei aufgetretene Quantisierungsfehler von der zweiten Stufe gespeichert. Während die zweite Stufe den Quantisierungsfehler der ersten Stufe des ersten Eingangswert verarbeitet, kann die erste Stufe bereits den nächsten zweiten Eingangswert verarbeiten. Auf diese Weise wird effektiv mit jedem Verarbeitungsschritt der Stufen mit der Verarbeitung eines neuen Eingangswerts begonnen bzw. fällt mit jedem Bearbeitungsschritt der Stufen ein neues Wandlungsergebnis eines Eingangswerts an. Die von den einzelnen Stufen gewonnenen Quantisierungsergebnisse müssen dazu jedoch in geeigneter Weise miteinander verknüpft werden. Dazu können die Quantisierungsergebnisse der Stufen in Zwischenspeichern zwischengespeichert werden, wobei jeder Zwischenspeicher den Wert der zugeordneten Stufe zuzüglich dem gespeicherten Wert des Zwischenspeichers der vorangegangenen Stufe speichert. Mit der fortschreitenden Verarbeitung eines Eingangswerts bzw. der bei der Verarbeitung anfallenden Quantisierungsfehler in den Stufen werden auf diese Weise parallel die dabei anfallenden Quantisierungsergebnisse mitgeschoben und aufsummiert. Denkbar ist auch bei einem Pipeline-ADC eine Fehlerkorrektur, indem die Verstärkung der Verstärker in den einzelnen Stufen und die Auflösung der Quantisierer in den nachfolgenden Stufen derart aufeinander abgestimmt wird, dass bezogen auf das Gesamtwandlungsergebnis bestimmte Bits gleichzeitig in zwei benachbarten Stufen gewandelt werden. Auf diese Weise können Fehler der Quantisierer in den einzelnen Stufen ausgeglichen werden und Linearitätsfehler korrigiert werden.

Bei derartigen Pipeline-ADC wird der Quantisierungsfehler bei der letzten Stufe abgegriffen. Die Rückkopplung auf nachfolgende Eingangswerte kann mit besonders geringem Aufwand bewerkstelligt werden, indem der Quantisierungsfehler analog in eine vorangegangene Stufe rückgekoppelt wird und dort das ohnehin vorhandene Subtrahierglied beaufschlagt.

Die vorliegende Erfindung ist auch bei Parallel-Wandlern bzw. Flash-Wandlern einsetzbar, bei denen der Eingangswert mit einer Reihe vieler Vergleichsspannungen verglichen wird, wobei die Ergebnisse der Vergleiche prioritätscodiert werden. Die Vergleichsspannungen werden insbesondere an einer Reihenschaltung von Widerständen abgegriffen, wobei an die Reihenschaltung eine Referenzspannung angelegt wird. Maßgeblich für das Wandlungsergebnis ist bei einem derartigen ADC der Vergleich, an dem die geringste Spannungsdifferenz zwischen dem Eingangswert und der Vergleichsspannung auftritt. In der Praxis liefern die Vergleiche zwischen den Vergleichsspannungen und dem Eingangswert einen Digitalwert, wenn die Vergleiche beispielsweise als Komparatoren geschaltet sind, so dass für das Wandlungsergebnis der Komparator maßgeblich ist, der für die höchste Vergleichsspannung noch anzeigt, dass der Eingangswert über der Vergleichsspannung liegt. Ebenso kann als maßgeblicher Komparator der Komparator verwendet werden, der für die niedrigste Vergleichsspannung anzeigt, dass die Vergleichsspannung unter dem Eingangswert liegt. Bei einem derartigen ADC muss das Quantisierungsergebnis an dem Vergleicher bzw. Komparator abgegriffen werden, der für das Wandlungsergebnis maßgeblich war. Dazu muss beispielsweise mit Hilfe eines Multiplexers die Möglichkeit geschaffen werden, die Eingangsdifferenzspannung von jedem Vergleicher bzw. Komparator auswählen zu können, um diesen Quantisierungsfehler rückkoppeln zu können.

Vorteilhafterweise wird der Quantisierer mit einer Frequenz betrieben, die mehr als das Doppelte der höchsten im zu wandelnden Nutzspektralbereich auftretenden Frequenz ist. Anders ausgedrückt, wird vorzugsweise Oversampling betrieben, um das Quantisierungsrauschen verringern zu können.

Die Rückkopplung des Quantisierungsfehlers auf folgende Eingangswerte geschieht vorzugsweise in der Form, dass das Quantisierungsrauschen aus dem Nutzspektralbereich hin zu höherfrequenten Spektralbereichen verschoben wird, so dass im Nutzspektralbereich das Quantisierungsrauschen verringert werden kann.

Die Erfindung wird nachfolgend anhand bevorzugter Ausführungsbeispiele unter Bezugnahme auf die beigefügten Zeichnungen näher erläutert.
Figur 1 ist eine schematische Darstellung eines ersten Ausführungsbeispiels der vorliegenden Erfindung,
Figur 2 ist eine detaillierte Darstellung des Schaltungsaufbaus eines Analog-Digital-Wandlers nach einem zweiten Ausführungsbeispiel der vorliegenden Erfindung,
Figur 3 ist ein Simulationsdiagramm zur Veranschaulichung eines Analog-Digital-Wandlers gemäß einem dritten Ausführungsbeispiel der vorliegenden Erfindung,
Figur 4 ist der schematische Aufbau eines Quantisierers zur Verwendung in einem Analog-Digital-Wandler nach der ersten oder dritten Ausführungsform der vorliegenden Erfindung,
Figur 5 ist eine schematische Darstellung eines Analog-Digital-Wandlers gemäß einer vierten Ausführungsform der vorliegenden Erfindung, und
Figur 6 ist die Darstellung einer Stufe des Analog-Digital-Wandlers gemäß Figur 5.

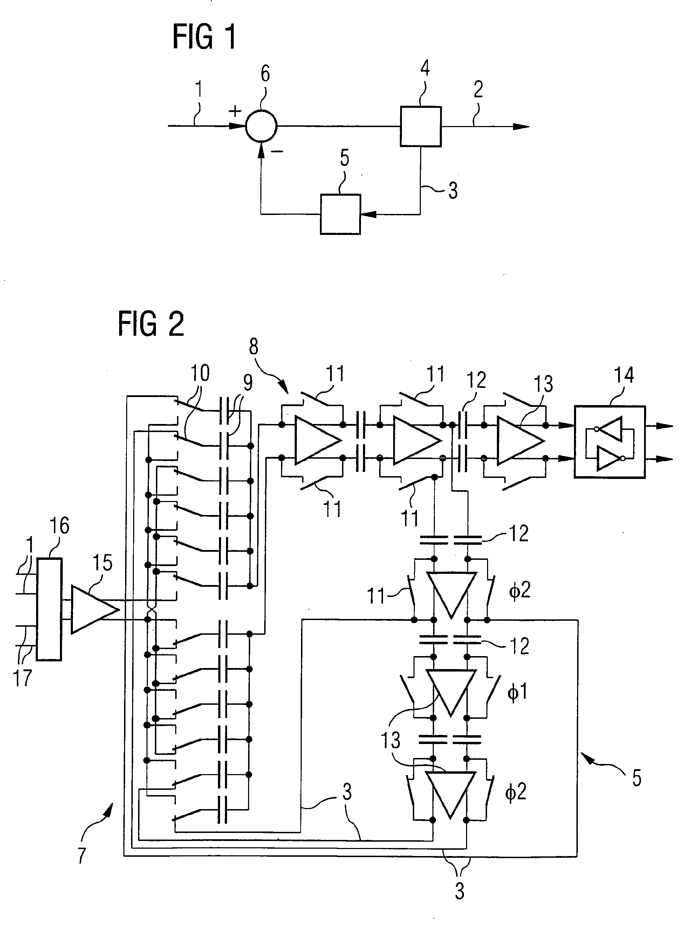

Der in Figur 1 schematisch dargestellte Analog-Digital-Wandler dient zum Erzeugen von digitalen Ausgangswerten 2 in Abhängigkeit von analogen zeitdiskreten Eingangswerten 1. Dazu weist der Analog-Digital-Wandler einen Quantisierer 4 auf, der nach jeder Wandlung den Quantisierungsfehler 3 analog ausgibt. Der Quantisierungsfehler 3 wird von einem Zwischenspeicher 5 zwischengespeichert und mit negativen Vorzeichen auf die Eingangswerte 1 rückgekoppelt. Dazu wird in einem Subtrahierglied 6 das Ausgangssignal des Zwischenspeichers 5 vom Eingangswert 1 abgezogen. Die dabei auftretende Differenzspannung wird dem Eingang des Quantisierers 4 zugeführt. Nach einer Wandlung des Quantisierers 4 wird der dabei entstandene Quantisierungsfehler 3 vom Zwischenspeicher 5 gespeichert und auf das Subtrahierglied 6 geschaltet. Vom nächsten Eingangswert 1 wird somit der Quantisierungsfehler der vorangegangenen Wandlung subtrahiert und der Quantisierer 4 mit der vom Subtrahierglied gewonnen Differenz beaufschlagt, worauf der bei dieser Wandlung entstandene Quantisierungsfehler zur Subtraktion des wiederum nächsten Eingangswerts 1 in den Zwischenspeicher 5 geladen wird.

Wenn angenommen wird, dass die Eingangswerte 1 ein Signal bilden, in dessen Spektralbereich eine sog. Grenzfrequenz die höchste auftretende Frequenz ist, wird der Quantisierer 4 mit einer Wandlungsfrequenz betrieben, die über dem Doppelten der Grenzfrequenz liegt. Vorzugsweise beträgt die Wandlungsfrequenz des Quantisierers 4 ganzzahlige Vielfache der doppelten Grenzfrequenz und insbesondere entspricht das Verhältnis der Wandlungsfrequenz des Quantisierers 4 und der doppelten Grenzfrequenz einer Zweierpotenz. Das heißt, dass der in Figur 1 dargestellte Analog-Digital-Wandler im Oversamplingbetrieb arbeitet.

Durch die erfindungsgemäße Rückkopplung des analogen Quantisierungsfehlers wird erreicht, dass das Quantisierungsrauschen aus dem Spektralbereich bis zur Grenzfrequenz hin zu Spektralbereichen höherer Frequenzen hin verschoben wird und somit das Quantisierungsrauschen im Spektralbereich unterhalb der Grenzfrequenz verringert wird. Je größer das Verhältnis zwischen der Wandlungsfrequenz des Quantisierers 4 und der Grenzfrequenz ist, umso wirkungsvoller wird das Quantisierungsrauschen im Nutzspektralbereich unterhalb der Grenzfrequenz verringert.

Da bei dem Analog-Digital-Wandler gemäß dem ersten Ausführungsbeispiel der Quantisierungsfehler nur um einen Wandlungsschritt verzögert wird und auf den jeweils nachfolgenden Eingangswert rückgeführt wird, spricht man im vorliegenden Fall von Noise-Shaping erster Ordnung.

In Figur 2 ist ein Analog-Digital-Wandler gemäß einem zweiten Ausführungsbeispiel der vorliegenden Erfindung dargestellt, bei dem Noise-Shaping zweiter Ordnung realisiert ist. Der in Figur 2 dargestellte Analog-Digital-Wandler arbeitet nach dem Prinzip der sukzessiven Approximation. Dazu umfasst die dargestellte Schaltung einen Digital-Analog-Wandler 7, der aus parallelen Kondensatoren 9 besteht, die an einem Ende verbunden sind und deren andere Enden mittels Schalter 10 auf einen der beiden differenziellen Ausgänge eines Eingangspuffers 15 geschaltet werden können. Der Eingangspuffer 15 wird mittels eines Multiplexers 16 gesteuert entweder von einem differenziellen Eingangswert 1 oder einer differenziellen Referenzspannung 17 beaufschlagt. Der Ausgang des Digital-Analog-Wandlers 7 beaufschlagt einen Komparator 8, der aus drei in Serie geschalteten Differenzverstärkern 13 besteht, wobei zwischen dem 1. und dem 2. und dem 2. und dem 3. Differenzverstärker 13 jeweils ein Koppelkondensator 12 vorgesehen ist und zusätzlich jeder Differenzverstärker 13 mittels eines Schalters 11 enabled bzw. aktiviert werden kann. Der Ausgang des letzten Differenzverstärkers 13 des Komparators 8 beaufschlagt ein Latch 14, indem in digitaler Form das Ergebnis des Komparators 8 vorliegt.

Zur Wandlung eines Eingangswerts 1 wird dieser mit Hilfe des Multiplexers 16 auf den Eingangspuffer 15 geschaltet. Durch geeignete Ansteuerung der Schalter 10 wird der Eingangswert 1 in Kondensatoren 9 geladen, worauf der Multiplexer 16 umschaltet und als nächstes den Eingangspuffer 15 mit der Referenzspannung 17 beaufschlagt. In der anschließenden Phase der sukzessiven Approximation werden die Schalter 10 von einer nicht dargestellten Logik derart angesteuert, dass durch unterschiedliche Aufschaltung der an den differenziellen Ausgängen des Eingangspuffers 15 erscheinenden Referenzspannung 17 auf die Kondensatoren 9 das differenzielle Ausgangssignal am Digital-Analog-Wandler 7 möglichst gering wird. Dazu wird nach jeder Ansteuerung der Schalter 10 mit Hilfe des Komparators 8 das Vorzeichen des differenziellen Ausgangssignals des Digital-Analog-Wandlers 7 ermittelt und über das Latch 14 an die Logik zur sukzessiven Approximation weitergegeben. Am Ende der Phase der sukzessiven Approximation liegt am Ausgang des Digital-Analog-Wandlers 7 der Quantisierungsfehler analog an. Dieser wird von einem mehrstufigen Zwischenspeicher 5 übernommen. Der Zwischenspeicher 5 des Analog-Digital-Wandlers nach der zweiten Ausführungsform der vorliegenden Erfindung weist insgesamt drei Differenzverstärker 13 mit zugeordneten Aktivierungsschaltern 11 auf, wobei jedem Eingang eines Differenzverstärkers 13 ein Koppelkondensator 12 vorgeschaltet ist. Die drei Differenzverstärker 13 des Zwischenspeichers 5 sind in Figur 2 vertikal angeordnet. Nach Ende der Phase der sukzessiven Approximation wird der Quantisierungsfehler der vergangenen Wandlung in den Koppelkondensator 12 des obersten Differenzverstärkers 13 übernommen. Bei geschlossenen Aktivierungsschaltern 11 des obersten Differenzverstärkers 13 des Zwischenspeichers 5 wird der Quantisierungsfehler differenziell an den obersten bzw. den untersten Kondensator 9 weitergegeben. Die in diese beiden Kondensatoren geladene Spannung wird in der nächsten Wandlungsphase vom Eingangswert 1 subtrahiert. Dies geschieht durch Ladungsverteilung, wenn der nächste Eingangswert 1 durch den Multiplexer 16, den Eingangspuffer 15 und geeignet geschaltete Schalter 10 in einige der anderen Kondensatoren 9 geladen worden ist. Auf diese Weise wird der Quantisierungsfehler einer vorangegangenen Wandlung mit negativen Vorzeichen auf den jeweils folgenden Eingangswert 1 rückgekoppelt.

Der Zwischenspeicher 5 besitzt noch zwei weitere Differenzverstärker 13, mit denen der Quantisierungsfehler aus dem obersten Differenzverstärker 13 zwischengespeichert werden kann, so dass sich ein zweistufiger Zwischenspeicher 5 ergibt, mit dem die Quantisierungsfehler der zwei jeweils vorangegangenen Wandlungen gespeichert werden können. Der Quantisierungsfehler, der am untersten Differenzverstärker 13 des Zwischenspeichers 5 anliegt, stammt von der vorvorigen Wandlung und wird ebenfalls auf dem Digital-Analog-Wandler 7 rückgekoppelt. Mit Hilfe der Kapazität des Kondensators 9, in den der Quantisierungsfehler zum Rückkoppeln geladen wird und durch Ansteuerung der Schalter 10 bei der Umverteilung der Ladung zum Rückkoppeln der gespeicherten Quantisierungsfehler auf den nächsten Eingangswert 1 kann der Faktor festgelegt werden, mit dem ein Quantisierungsfehler auf den Eingangswert 1 rückgekoppelt wird. Im vorliegenden Fall wird der Quantisierungsfehler der eine Wandlung vorausgegangenen Wandlung mit dem Faktor -2 und der Quantisierungsfehler der zwei Wandlungen vorausgegangen Wandlung mit dem Faktor +1 rückgekoppelt.

Mit Hilfe des in Figur 2 dargestellten Analog-Digital-Wandlers mit Noise-Shaping zweiter Ordnung wird das Quantisierungsrauschen im Nutzspektralbereich noch weiter verringert. Durch die Wahl eines Digital-Analog-Wandlers 7 mit Kondensatoren 9 entfällt vorteilhafterweise ein Sample-and-Hold-Glied, da der Eingangswert 1 in einem Kondensator 9 gesampelt werden kann.

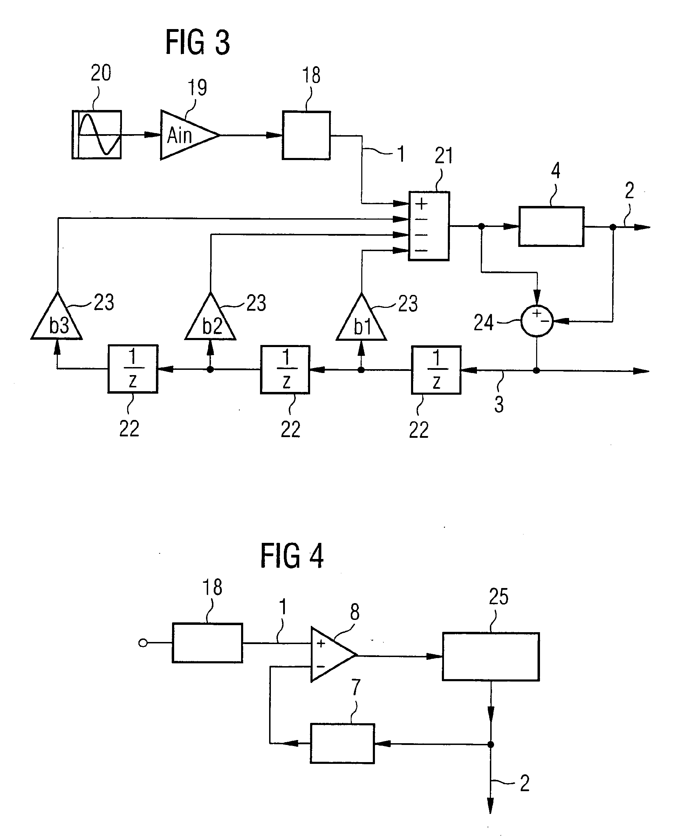

In Figur 3 ist ein Blockschaltbild eines Digital-Analog-Wandlers gemäß einer dritten Ausführungsform der vorliegenden Erfindung dargestellt. Dabei sind zusätzliche Komponenten dargestellt, die nur zum Testen des Analog-Digital-Wandlers verwendet werden. Im vorliegenden Fall soll als Testsignal eine Sinusschwingung verwendet werden, die von einer Signalquelle 20 erzeugt und von einem Vorverstärker 19 verstärkt wird. Das Ausgangssignal des Vorverstärkers 19 wird in einem Sample-and-Hold-Glied 18 in ein zeitdiskretes Analogsignal 1 bestehend aus zeitdiskreten analogen Eingangswerten 1 umgewandelt. Die Eingangswerte 1 bzw. das Eingangssignal 1 beaufschlagt ein Addier- bzw. Subtrahierglied 21, das eine Linearkombination anliegender Eingangssignale bildet und dessen Ausgangssignal einen Quantisierer 4 beaufschlagt. In der Praxis wird ein Quantisierer 4 verwendet, in dem nach einer Wandlung der Quantisierungsfehler der Wandlung in analoger Form abgegriffen werden kann. Da in Figur 3 zur Veranschaulichung nur übliche Funktionselemente verwendet wurden, wird der Quantisierungsfehler 3 durch Differenzbildung zwischen dem Eingang des Quantisierers 4 und dessen Ausgang gebildet. Dazu ist ein Differenzierglied 24 vorgesehen, in dem von dem Ausgangssignal des Addier- bzw. Subtrahierglieds 21 bzw. dem Eingangssignal des Quantisierers 4 und dem Ausgangssignal 2 des Quantisierers 4 gebildet wird. Dieses Subtrahierglied 24 ist im Diagramm gemäß Figur 3 nur zum besseren Verständnis eingeführt und tritt in der Praxis nicht auf. Stattdessen wird der Quantisierungsfehler 3 direkt am Quantisierer 4 abgegriffen. Der Quantisierungsfehler 3 beaufschlagt eine Reihe mehrerer Verzögerungsglieder 22, die das jeweils an ihnen anliegende Eingangssignal um einen Zeitschritt verzögern, wobei die Zeitschritte dem Takt der Wandlungen entsprechen, so dass ein Zeitschritt einer Wandlung entspricht. Dies bedeutet, dass am Ausgang des ersten, rechts dargestellten Verzögerungsglieds 22 der Quantisierungsfehler 3 der vorausgegangenen Wandlung anliegt. Am Ausgang des zweiten, in der Mitte dargestellten Verzögerungsglieds 22 liegt der Quantisierungsfehler 3 der zwei Wandlungen vorausgegangenen Wandlung an. Entsprechend liegt am Ausgang des letzten, links dargestellten Verzögerungsglieds 22 der Quantisierungsfehler der drei Wandlungen vorausgegangenen Wandlung an. Das Ausgangssignal jedes Verzögerungsglieds 22 wird von einem Verstärker 23 mit einem Faktor multipliziert und zu einem Eingang mit negativen Vorzeichen des Addier- bzw. Subtrahierglieds 21 geleitet. Der Quantisierer 4 wird somit mit Eingangswerten 1 beaufschlagt, auf die die Quantisierungsfehler 3 der jeweils drei vorausgegangenen Wandlungen mit unterschiedlichen Faktoren rückgekoppelt werden. Der Faktor b1 für den um eine Wandlung verzögerten Quantisierungsfehler 3 beträgt -3, der Faktor b2 für den um zwei Wandlungen verzögerten Quantisierungsfehler 3 beträgt +3 und der Faktor b3 für den um drei Wandlungen verzögerten Quantisierungsfehler 3 beträgt -1.

Mit dem in Figur 3 schematisch dargestellten Analog-Digital-Wandler kann somit Noise-Shaping dritter Ordnung realisiert werden, wobei im unteren Frequenzbereich das Quantisierungsrauschen und damit der Signalrauschabstand weiter verbessert werden kann gegenüber einem Analog-Digital-Wandler ohne Rückkopplung des Quantisierungsfehlers.

Wie eingangs bereits ausgeführt, kann die vorliegende Erfindung bei jedem Quantisierer angewendet werden, bei dem der Quantisierungsfehler nach jeder Wandlung in analoger Form vorliegt bzw. abgegriffen werden kann.

Zur Verwendung in einem Analog-Digital-Wandler nach dem ersten und dritten Ausführungsbeispiel sind Quantisierer geeignet, die nach dem Prinzip der sukzessiven Approximation arbeiten. In Figur 4 ist schematisch das Blockschaltbild eines solchen Quantisierers dargestellt. Dabei wird mit Hilfe eines Sample-and-Hold-Glieds 18 ein Eingangssignal 1 aus zeitdiskreten analogen Eingangswerten 1 geschaffen. Die Eingangswerte 1 werden von einem Komparator 8 mit dem Ausgangssignal eines Digital-Analog-Wandlers 7 verglichen, wobei das Ausgangssignal des Komparators 8 von einer Steuereinrichtung 25 ausgewertet wird, das auch Sukzessive-Approximation-Register genannt wird. Die Steuereinrichtung 25 steuert nach dem bekannte Wägeverfahren digital den Digital-Analog-Wandler 7 derart, dass in einer Wandlung der Unterschied zwischen einem Eingangswert 1 und dem analogen Ausgangssignal des Digital-Analog-Wandlers 7 möglichst gering wird. Am Ende der Wandlung stellt der Digitalwert, mit dem der Digital-Analog-Wandler 7 beaufschlagt wird, das Wandlungsergebnis 2 dar. Der Quantisierungsfehler kann in einem derartigen Fall als Differenzspannung zwischen den beiden Eingängen des Komparators 8 nach jeder Wandlung abgegriffen werden. Als Digital-Analog-Wandler kommen alle bekannten Ausführungsformen in Frage.

Um den in Figur 4 dargestellten Quantisierer zu einem erfindungsgemäßen Analog-Digital-Wandler zu erweitern, müssen zusätzlich zu den in Figur 4 dargestellten Komponenten der Zwischenspeicher 5 und das Addier- bzw. Subtrahierglied 6 gemäß Figur 1 vorgesehen werden. Der Quantisierungsfehler 3 wird mittels eines nicht dargestellten Differenzverstärkers von den Eingängen des Komparators 8 am Ende jeder Wandlung abgegriffen und in dem Zwischenspeicher 5 gespeichert.

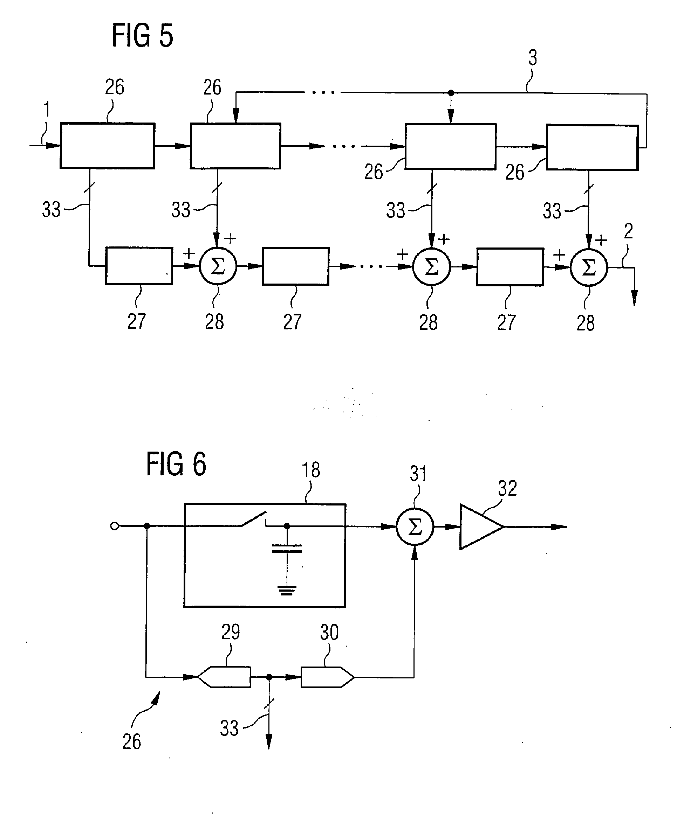

In den Figuren 5 und 6 ist ein Teil einer weiteren Ausführungsform der vorliegenden Erfindung dargestellt. Dabei handelt es sich um einen Pipeline-Quantisierer mit Rückkopplung des Quantisierungsfehlers 3 vorausgegangener Wandlungen. In Figur 1 ist ein Blockschaltbild des erfindungsgemäßen Analog-Digital-Wandlers dargestellt, wobei der Pipeline-Quantisierer einen analogen Strang bestehend aus den Blöcken 26 und einen digitalen Strang bestehend aus den Zwischenspeichern 27 und den digitalen Addiergliedern 28 aufweist. Der analoge Strang kann in mehrere Stufen unterteilt werden, wobei eine Stufe einem Block 26 entspricht.

In Figur 6 ist der Aufbau eines Blocks 26 einer Stufe des Pipeline-Quantisierers dargestellt. Jeder Block 26 umfasst ein Sample-and-Hold-Glied 18, mit dem ein links am jeweiligen Eingang anliegendes Signal zwischengespeichert werden kann. Gleichzeitig wird das jeweils links anliegende Eingangssignal von einem Stufenquantisierer 29, der ein gewöhnlicher Analog-Digital-Wandler sein kann, mit einer bestimmten Auflösung quantisiert. Der Stufenquantisierer 29 liefert ein digitales Ausgangssignal 33, das wiederum einen Digital-Analog-Wandler 30 beaufschlagt, dessen Ausgangssignal in einem Subtrahierglied 31 von dem vom Sample-and-Hold-Glied 18 gespeicherten Signal subtrahiert wird. Das Differenzsignal am Ausgang des Subtrahierglieds 31 wird von einem Verstärker 32 verstärkt und als Ausgangssignal zu der nächsten Stufe weitergeleitet. Im Betrieb wird an einem Block 26 gemäß Figur 6 links ein Wert angelegt, der mit einer bestimmten Auflösung digitalisiert und digital als Wert 33 ausgegeben wird. Gleichzeitig liegt rechts am Ausgang des Verstärkers 32 der verstärkte Quantisierungsfehler der Quantisierung in diese Stufe an.

Durch die Kettenstruktur in Figur 5 wird in einer rechts darauffolgenden Stufe von dem darin enthaltenen Block 26 der Quantisierungsfehler des vorausgegangenen Blocks quantisiert. Wenn beispielsweise vier Stufen vorgesehen sind und jede Stufe mit einer Auflösung von 2 Bit arbeitet, werden in der ersten, links dargestellten Stufe die zwei höchstwertigen Bits gewandelt, d.h., das MSB Bit 7 und Bit 6, in der darauffolgenden Stufe Bit 5 und Bit 4, in der dritten Stufe Bits 3 und 2 und in der letzten Stufe die Bits 1 und 0. Um die zeitlich versetzt anfallenden Quantisierungsergebnisse 33 zu dem Gesamtwandlungsergebnis zusammenzusetzen, werden die Quantisierungsergebnisse 33 der einzelnen Blöcke 26 der einzelnen Stufen im digitalen Strang mit Hilfe der Zwischenspeicher 27 nach rechts weitergeschoben. Dabei wird von einem Zwischenspeicher 27 das Summationsergebnis eines jeweils vorgeschalteten digitalen Addierglieds 28 gespeichert. Dieses bildet die Summe des vorausgegangenen Zwischenspeichers und des Quantisierungsergebnisses des zugeordneten Blocks 26, so dass nach einer Anzahl von Wandlungsschritten, die der Anzahl der Stufen bzw. Blöcke 26 entspricht, am letzten, rechts dargestellten Summationsglied 28 das Wandlungsergebnis 2 anliegt.

Mit Hilfe der Sample-and-Hold-Glieder 18 in jedem Block 26 können die einzelnen Blöcke 26 parallel arbeiten, so dass während ein Block das Eingangssignal 1 bzw. den Quantisierungsfehler des vorhergehenden Blocks 26 einer Wandlung quantisiert, kann der vorausgehende Block, der jeweils links davon dargestellt ist, bereits den Eingangswert 1 bzw. den Quantisierungsfehler des vorausgehenden Blocks 26 der nächsten Wandlung bearbeiten. Mit jedem Quantisierungsvorgang der Blöcke 26 wird somit eine Wandlung eines Eingangswerts 1 vervollständigt bzw. fällt en Wandlungsergebnis 2 an.

Am Ausgang des letzten, rechts dargestellten Blocks 26 liegt der Quantisierungsfehler 3 für die einzelnen Wandlungen an. Dieser wird gemäß der vorliegenden Erfindung rückgekoppelt, wobei auf Grund der zeitlich gestaffelten Durchführung der Wandlung in verschiedenen Stufen, der Quantisierungsfehler 3 ohne Zwischenspeicher rückgekoppelt werden kann, indem er auf die Blöcke 26 vorausgehender Stufen rückgekoppelt wird. Der Quantisierungsfehler 3 wird je nachdem, welcher Ordnung das gewünschte Noise-Shaping ist, auf eine bestimmte Anzahl vorausgehender Stufen rückgekoppelt. Der rückgekoppelte Quantisierungsfehler wird dabei auf das Addierglied 31 innerhalb jedes beaufschlagten Blocks 26 geschaltet, wobei ein Verstärker zwischengeschaltet sein kann, der den rückgekoppelten Quantisierungsfehler 3 mit einem bestimmten Faktor multipliziert. Auf diese Weise kann mit geringem Aufwand die vorliegende Erfindung bei einem Pipeline-Quantisierer realisiert werden. Die Auflösung der Stufenquantisierer 29 kann auch 1 Bit betragen.

## Patentansprüche

1. Verfahren zur Analog-Digital-Wandlung zeitdiskreter, analoger Eingangswerte (1) mittels eines Quantisierers (4), der derart eingerichtet ist, dass er nach einer Wandlung eines Eingangswerts (1) einen zugehörigen digitalen Ausgangswert (2) liefert,
**dadurch gekennzeichnet,**
**dass** nach jeder Wandlung eines Eingangswerts (1) ein Quantisierungsfehler (3) des Quantisierers (4) analog ermittelt und analog auf wenigstens einen folgenden Eingangswert (1) rückgekoppelt wird.

2. Verfahren nach Anspruch 1,
**dadurch gekennzeichnet,**
**dass** die Wandlungsfrequenz des Quantisierers (4) größer als das Doppelte der höchsten im zu wandelnden Nutzspektralbereich der Eingangswerte (1) enthaltenen Frequenz ist.

3. Verfahren nach Anspruch 2,
**dadurch gekennzeichnet,**
**dass** die Wandlungsfrequenz des Quantisierers (4) ein ganzzahliges Vielfaches der höchsten im zu wandelnden Nutzspektralbereich enthaltenen Frequenz ist.

4. Verfahren nach einem der vorhergehenden Ansprüche,
**dadurch gekennzeichnet,**
**dass** der Quantisierungsfehler (3) derart analog rückgekoppelt wird, dass das Quantisierungsrauschen wenigstens zum Teil aus dem zu wandelnden Nutzspektralbereich heraus zu höherfrequenten Spektralbereichen verschoben wird.

5. Verfahren nach einem der vorhergehenden Ansprüche,
**dadurch gekennzeichnet,**
**dass** der Quantisierungsfehler (3) einer Wandlung des Quantisierers (4) auf mehrere folgende Eingangswerte (1) rückgekoppelt wird, wobei der Quantisierungsfehler (3) in Abhängigkeit davon, wie viele Wandlungen des Quantisierers (4) der Eingangswert (1) in der Zukunft liegt, auf dem der Quantisierungsfehler rückgekoppelt wird, mit einem bestimmten Faktor (b1-b3) rückgekoppelt wird.

6. Verfahren nach einem der vorhergehenden Ansprüche,
**dadurch gekennzeichnet,**
**dass** der Quantisierungsfehler (3) mittels einen Sample-and-Hold-Gliedes erfasst und gespeichert wird.

7. Verfahren nach Anspruch 6,
**dadurch gekennzeichnet,**
**dass** die Quantisierungsfehler (3) von Wandlungen des Quantisierers (4) in einer Verzögerungskette aus mehreren Sample-and-Hold-Gliedern (11, 12, 13) im Takt der Wandlungen des Quantisierers (4) weitergereicht werden.

8. Verfahren nach einem der vorhergehenden Ansprüche,
**dadurch gekennzeichnet,**
**dass** der Quantisierungsfehler (3) durch Abgreifen eines im Quantisierers (4) auftretenden Signals ermittelt wird.

9. Verfahren nach einem der vorhergehenden Ansprüche,
**dadurch gekennzeichnet,**
**dass** der Quantisierer (4) ein Quantisierer gemäß dem Verfahren der sukzessiven Approximation ist.

10. Verfahren nach einem der Ansprüche 1 bis 8,
**dadurch gekennzeichnet,**
**dass** der Quantisierer (4) ein Pipline-Analog-Digital-Wandler ist.

11. Verfahren nach Anspruch 10,
**dadurch gekennzeichnet,**
**dass** der Quantisierungsfehler (3) an der letzten Stufe (26) des Pipeline-Analog-Digital-Wandlers abgegriffen wird und zum Rückkoppeln auf darauffolgende Wandlungen des Quantisierers (4) auf eine vorhergehende Stufe (26) des Pipeline-Analog-Digital-Wandlers rückgekoppelt wird.

12. Verfahren nach einem der Ansprüche 1 bis 8,
**dadurch gekennzeichnet,**
**dass** der Quantisierer (4) nach dem Parallelverfahren arbeitet, wobei die Eingangswerte (1) mit einer Mehrzahl von Vergleichsspannungen binär verglichen werden, die Ergebnisse der Vergleiche prioritätsdekodiert werden und der Quantisierungsfehler (3) durch Bildung der Differenz zwischen dem Eingangswert (1) und der Vergleichsspannung, deren binärer Vergleich mit dem Eingangswert (1) bei der Prioritätscodierung die höchste Priorität hatte.

13. Vorrichtung zur Analog-Digital-Wandlung zeitdiskreter, analoger Eingangswerte (1) mit einem Quantisierer (4), der derart eingerichtet ist, dass er nach einer Wandlung eines Eingangswerts (1) einen zugehörigen digitalen Ausgangswert (2) liefert,
**dadurch gekennzeichnet,**
**dass** die Vorrichtung eine Rückkopplung (3, 5, 6) aufweist, die derart eingerichtet ist, dass sie nach einer Wandlung eines Eingangswerts (1) einen analog ermittelten Quantisierungsfehler (3) des Quantisierers (4) analog auf wenigstens folgenden Eingangswert (1) rückkoppelt.

14. Vorrichtung nach Anspruch 13,
**dadurch gekennzeichnet,**
**dass** die Vorrichtung zur Durchführung eines Verfahrens nach einem der Ansprüche 1 bis 12 eingerichtet ist.
